# EUROPÄISCHE PATENTSCHRIFT

(11) **EP 2 520 140 B1**
(45) Veröffentlichungstag und Bekanntmachung des Hinweises auf die Patenterteilung: **26.12.2018**
(21) Anmeldenummer: 10800710.5
(22) Anmeldetag: 28.12.2010
(51) Int. Cl.: H05K 3/18, C25D 7/06, C25D 5/00, C25D 21/12

(54) **VERFAHREN UND VORRICHTUNG ZUM NASSCHEMISCHEN BEHANDELN VON BEHANDLUNGSGUT**
METHOD AND DEVICE FOR THE WET CHEMICAL TREATMENT OF MATERIAL FEEDSTOCK
PROCÉDÉ ET DISPOSITIF DE TRAITEMENT CHIMIQUE HUMIDE DE PRODUITS À TRAITER

(30) Priorität: 28.12.2009 DE 102009060676
(43) Veröffentlichungstag der Anmeldung: 07.11.2012
(73) Patentinhaber: Atotech Deutschland GmbH, 10553 Berlin (DE)
(72) Erfinder: SKUPIN, Andreas, 90469 Nürnberg (DE); BRUCKNER, Helmut, 53783 Eitorf (DE); LOWINSKI, Christian, 16547 Birkenwerder (DE)
(74) Vertreter: Banzer, Hans-Jörg
(86) Internationale Anmeldenummer: PCT/EP2010/007970
(87) Internationale Veröffentlichungsnummer: WO 2011/079950

(56) Entgegenhaltungen:
- EP-A2- 0 730 395
- WO-A1-2009/117226
- US-A- 5 304 297
- DATABASE WPI Week 198843 Thomson Scientific, London, GB; AN 1988-302989 XP002632679, -& JP 63 221693 A (HITACHI CHEM CO LTD) 14. September 1988 (1988-09-14)

## Beschreibung

Die Erfindung betrifft ein Verfahren und eine Vorrichtung zum nasschemischem Behandeln von Behandlungsgut. Insbesondere betrifft die Erfindung eine derartige Vorrichtung und ein derartiges Verfahren, bei der bzw. bei dem ein Behandlungsgut in einer Durchlaufanlage transportiert und mit Behandlungsflüssigkeit behandelt wird.

Bei der Bearbeitung von flächigem Behandlungsgut, wie beispielsweise Leiterplatten in der Leiterplattenindustrie, findet eine Behandlung des Behandlungsgutes häufig in einer nasschemischen Prozesslinie statt. In einer Durchlaufanlage kann das Behandlungsgut durch ein Behandlungsmodul oder mehrere Behandlungsmodule transportiert werden, in dem bzw. denen es mit einer Behandlungslösung oder sequentiell mit unterschiedlichen Behandlungslösungen behandelt wird. Die Behandlungslösung kann mithilfe einer Pumpe an das Behandlungsgut gefördert und über Behandlungsorgane abgegeben werden. Dabei kann Luftsauerstoff in die Behandlungslösung gelangen.

Bei einigen Behandlungslösungen kann der Eintrag von Sauerstoff die Behandlungslösung selbst und/oder den Behandlungsprozess des Behandlungsgutes beeinträchtigen. Beispielsweise kann der Sauerstoffeintrag Oxidationsvorgänge in einer Elektrolytlösung begünstigen. Ein Beispiel für eine Behandlungslösung, die durch einen Sauerstoffeintrag beeinflusst werden kann, ist eine Zinnlösung. In der EP 545 216 A2 wird beispielsweise beschrieben, dass ein Eintrag von aus der Luft stammendem Sauerstoff in ein Zinnbad zu einer Anreicherung von Sn(IV)-Ionen aufgrund einer Oxidation von Sn(II)-Ionen und zu einer Anreicherung des Cu(I)-Thioharnstoff-Komplexes bis zu einer Konzentration, in der die Löslichkeitsgrenze überschritten wird und der Komplex als Niederschlag ausfällt, führen kann.

Allgemein können bestimmte Behandlungslösungen durch einen Sauerstoffeintrag derart beeinflusst werden, dass Partikel ausfallen und sich ein entsprechender Schlamm in dem Behandlungsmodul bildet. Dies kann dann zu einer Verringerung der Badlebensdauer führen, die erhöhte Kosten für Chemikalien und Wartung bedingt. Der Schlamm kann zu einer Beeinträchtigung des Behandlungsgutes führen. Der Schlamm kann sich auch in strömungsarmen Bereichen der Prozesslinie ablagern, wobei die Entfernung des Schlamms den Wartungsaufwand erhöhen kann.

Ein Sauerstoffeintrag kann auch dazu führen, dass sich bei der Reaktion mit dem Behandlungsgut in der Behandlungslösung Schadgase bilden können, welche im Bad gelöst bleiben und zu einer Verringerung der Reaktivität führen.

Eine Behandlungslösung, bei der ein Sauerstoffeintrag in der Behandlungslösung die Behandlungslösung selbst, den Behandlungsvorgang des Behandlungsgutes oder den Betrieb der Prozesslinie bzw. eines Behandlungsmoduls negativ beeinflusst, wird im Folgenden als sauerstoff- oder luftempfindliche Behandlungslösung bezeichnet.

Um die Wirkungen des Sauerstoffeintrags in eine Behandlungslösung abzumildern, wird in der DE 101 32 478 C1 vorgeschlagen, Bäder beispielsweise mit metallischem Zinn in Kontakt zu bringen und dadurch zu regenerieren. Dabei werden Metallionen in einer hohen Oxidationsstufe zu Metallionen in einer niedrigen Oxidationsstufe reduziert. Dazu ist ein entsprechender Regenerator vorzusehen.

Die WO 2009/117226 A1, die als Grundlage für den Oberbegriff der unabhängigen Ansprüche dient, offenbart ein Verfahren und eine Vorrichtung zur Abscheidung eines Materials auf einem Behandlungsgut. In ein Bad kann ein Gas, beispielsweise Stickstoff, Helium, Argon, Wasserstoff oder Kohlenstoffdioxid eingebracht werden, um Sauerstoff zu verdrängen.

Der Erfindung liegt die Aufgabe zugrunde, ein verbessertes Verfahren und eine verbesserte Vorrichtung zum Behandeln von Behandlungsgut für eine Durchlaufanlage anzugeben. Insbesondere besteht ein Bedarf an einem derartigen Verfahren und einer derartigen Vorrichtung, bei dem bzw. bei der ein negativer Einfluss auf die Behandlungslösung und/oder auf den Behandlungsvorgang des Behandlungsgutes und/oder den Betrieb der Prozesslinie bzw. eines Behandlungsmoduls, der aus einem Sauerstoffeintrag resultieren kann, abgemildert wird. Insbesondere besteht ein Bedarf an einem derartigen Verfahren und einer derartigen Vorrichtung, bei dem bzw. bei der diese Probleme im kontinuierlichen Betrieb einer Durchlaufanlage abgemildert werden können, ohne die Behandlungsgeschwindigkeit wesentlich zu beeinflussen.

Erfindungsgemäß wird die Aufgabe gelöst durch ein Verfahren und eine Vorrichtung, wie sie in den unabhängigen Ansprüchen angegeben sind. Die abhängigen Ansprüche definieren bevorzugte oder vorteilhafte Ausführungsformen der Erfindung.

Nach einem Aspekt wird ein Verfahren zum nasschemischen Behandeln von Behandlungsgut in einer Durchlaufanlage angegeben, bei dem das Behandlungsgut durch einen Behandlungsbehälter transportiert und in dem Behandlungsbehälter mit einer Behandlungsflüssigkeit behandelt wird. Erfindungsgemäß wird ein Inertgas in den Behandlungsbehälter zugeführt.

Bei dem Behandlungsgut kann es sich insbesondere um ein flächiges Behandlungsgut, beispielsweise um eine Leiterplatte, eine Leiterfolie, ein Bahnmaterial oder dergleichen handeln. Das Behandlungsgut kann eine leitfähige Struktur aufweisen. Die Behandlungsflüssigkeit kann insbesondere eine Lösung sein, bei der ein Sauerstoffeintrag in der Behandlungslösung die Behandlungslösung selbst und/oder den Behandlungsvorgang des Behandlungsgutes und/oder den Betrieb der Prozesslinie bzw. eines Behandlungsmoduls negativ beeinflusst.

Das Zuführen von Inertgas führt zu einer Verdrängung von Luftsauerstoff in dem Behandlungsbehälter. Bei dem Verfahren kann die Sauerstoffkonzentration in dem Behandlungsbehälter verringert und somit der Eintrag von Sauerstoff in die Behandlungsflüssigkeit verringert werden. Insbesondere kann ein Gaspolster oberhalb eines Bades der Behandlungsflüssigkeit und unmittelbar angrenzend an die Badoberfläche erzeugt werden, das einen geringen Anteil an Sauerstoff oder keinen Sauerstoff enthält. Dies erlaubt es, in einer Durchlaufanlage, in der das Behandlungsgut in den Behandlungsbehälter und aus dem Behandlungsbehälter transportiert wird, einen Sauerstoffeintrag in die Behandlungslösung zu verringern.

Das Zuführen des Inertgases kann in einem Bereich oder in Bereichen des Behandlungsbehälters erfolgen, die von demjenigen Bereich oder denjenigen Bereichen beabstandet sind, an dem bzw. an denen Abluft aus dem Behandlungsbehälter abgegeben wird. Beispielsweise kann das Inertgas in wenigstens einem ersten Bereich des Behandlungsbehälters in den Behandlungsbehälter zugeführt werden, während das Inertgas in einem von dem ersten Bereich beabstandeten zweiten Bereich des Behandlungsbehälters aus dem Behandlungsbehälter abgegeben, beispielsweise abgesaugt oder abgezogen, wird. Dies erlaubt es, durch eine geeignete Anordnung des ersten Bereichs und des zweiten Bereichs Sauerstoff aus dem Behandlungsbehälter zu verdrängen.

Das Inertgas kann über einen Randbereich des Behandlungsbehälters aus dem Behandlungsmodul abgezogen werden. Der Randbereich kann an einem das Behandlungsmodul in Transportrichtung begrenzenden Abschnitt einer Hülle des Behandlungsbehälters angeordnet sein, beispielsweise an einer Trennwand zwischen dem Behandlungsbehälter und einem in der Durchlaufanlage benachbarten Behandlungsmodul. Das Zuführen des Inertgases in den Behandlungsbehälter kann zumindest in einem Bereich erfolgen, der von den zwei den Behandlungsbehälter in Transportrichtung begrenzenden Abschnitten der Hülle des Behandlungsbehälters beabstandet und insbesondere im Wesentlichen mittig zwischen diesen angeordnet ist. Dies erlaubt es, Sauerstoff über die Länge des Behandlungsbehälters zu verdrängen.

Der Behandlungsbehälter weist einen Einlaufschlitz, durch den das Behandlungsgut in den Behandlungsbehälter transportiert wird, und einen Auslaufschlitz, durch den das Behandlungsgut aus dem Behandlungsbehälter transportiert wird, auf, wobei das Inertgas durch den Einlaufschlitz und/oder den Auslaufschlitz aus dem Behandlungsbehälter abgegeben wird. Das Inertgas kann insbesondere durch den Einlaufschlitz und durch den Auslaufschlitz aus dem Behandlungsbehälter abgesaugt werden. Dies erlaubt es, Abluft durch einen Schlitz und insbesondere durch zwei Schlitze aus dem Behandlungsbehälter auszugeben, die in dem Behandlungsbehälter zum Durchführen des Behandlungsgutes vorgesehen sind. Ein Eindringen von Luft durch diese Schlitze in den Behandlungsbehälter kann entsprechend unterdrückt werden .

Ein Druck in einem Dampfraum des Behandlungsbehälters kann so eingestellt werden, dass er höher ist als ein Umgebungsdruck außerhalb des Behandlungsbehälters. Dadurch kann ein Eindringen von Luftsauerstoff aus der Umgebung in den Behandlungsbehälter, beispielsweise durch den Einlaufschlitz und/oder den Auslaufschlitz, verringert werden.

Das Inertgas kann kontinuierlich in den Behandlungsbehälter zugeführt werden. Dadurch kann im kontinuierlichen Betrieb einer Durchlaufanlage Sauerstoff aus dem Behandlungsbehälter verdrängt werden.

Das Inertgas kann wenigstens in die Behandlungsflüssigkeit eingebracht werden, um das Inertgas in den Behandlungsbehälter zuzuführen. Dies ermöglicht, dass in der Behandlungsflüssigkeit gelöster Sauerstoff oder in der Behandlungsflüssigkeit gelöste Schadgase, welche während des Behandlungsprozesses entstehen, aus der Behandlungsflüssigkeit ausgetrieben werden, wenn das Inertgas in den Behandlungsbehälter zugeführt wird.

Das Inertgas kann an einer Position in die Behandlungsflüssigkeit eingebracht werden, die unterhalb eines Badspiegels der Behandlungsflüssigkeit angeordnet ist. Insbesondere kann das Inertgas an einer Position in die Behandlungsflüssigkeit eingebracht werden, die mindestens 10 mm, insbesondere mindestens 100 mm unterhalb des Badspiegels angeordnet ist. Dadurch kann eine Schaumbildung unterdrückt, eine gleichmäßige Blasenverteilung erreicht und eine lange Kontaktzeit von Inertgasblasen mit dem Bad der Behandlungsflüssigkeit erzielt werden.

Weiterhin kann das Inertgas derart in die Behandlungsflüssigkeit eingebracht werden, dass eine Verwirbelung des Bades bzw. der Behandlungsflüssigkeit erzielt wird. Dadurch kann ein Aufwirbeln von in Restmengen möglicherweise noch vorhandenem Schlamm erreicht werden, so dass ein Filtrieren des Schlammes einfacher möglich ist. So kann eine Verlängerung von Wartungsintervallen und eine höhere Verfügbarkeit der Prozesslinie erreicht werden.

Der Behandlungsbehälter kann einen Sumpf aufweisen, in dem die Behandlungsflüssigkeit wenigstens bis zu einem Niveau angestaut wird und aus dem die Behandlungsflüssigkeit zu einem Behandlungsorgan gefördert wird, wobei das Inertgas unterhalb des Niveaus in den Behandlungsbehälter eingebracht wird. Dadurch kann das Inertgas gezielt so in die Behandlungsflüssigkeit eingebracht werden, dass sauerstoffarme Behandlungsflüssigkeit gefördert und über ein oder mehrere Behandlungsorgane abgegeben wird. Auf diese Weise kann bzw. können aus einem großen Anteil der Behandlungsflüssigkeit in dem Behandlungsbehälter Sauerstoff und/oder Schadgase ausgetrieben werden.

Das Inertgas kann insbesondere in einem Ansaugbereich einer Fördereinrichtung, die die Behandlungsflüssigkeit zu einem Behandlungsorgan fördert, in die Behandlungsflüssigkeit eingebracht werden. Insbesondere kann das Inertgas an einer Position oder in einem Bereich in die in dem Sumpf angestaute Behandlungsflüssigkeit eingebracht werden, an der bzw. in dem es einen großen Anteil von zu einer die Behandlungsflüssigkeit umwälzenden Fördereinrichtung strömender Flüssigkeit gibt und/oder an der bzw. in dem eine endliche Strömungsgeschwindigkeit zu einer Ansaugöffnung der Fördereinrichtung vorhanden ist.

Das Inertgas kann an einer Position oder in einem Bereich in die in dem Sumpf angestaute Behandlungsflüssigkeit eingebracht werden, die bzw. der höher als eine Ansaugöffnung der Fördereinrichtung in dem Sumpf angeordnet ist. Dadurch kann ein Ansaugen von Gasblasen vermieden werden, die die Fördereinrichtung schädigen könnten.

Eine Zuführeinrichtung zum Zuführen des Inertgases, insbesondere zum Einbringen des Inertgases in die Behandlungsflüssigkeit, kann so ausgestaltet sein, dass das Inertgas feinperlig eingebracht wird. Die Zuführeinrichtung kann eine poröse Fritte aufweisen, über die das Inertgas in die Behandlungsflüssigkeit eingebracht wird. Die Zuführeinrichtung kann auch einen mit einer Anordnung von kleinen Löchern versehenen Zuführabschnitt aufweisen, über die das Inertgas in die Behandlungsflüssigkeit eingebracht wird. Die Fritte oder der Abgabeabschnitt kann als rohrförmiges Kunststoffteil ausgebildet sein. Wenn das Inertgas feinperlig in die Behandlungsflüssigkeit eingebracht wird, kann ein hoher Grad der Inertgasnutzung erreicht werden. Zusätzlich können unerwünschte Spritzer verringert werden.

Ein Volumenstrom des in den Behandlungsbehälter zugeführten Inertgases kann eingestellt werden, um eine gewünschte Sauerstoffkonzentration in einem Dampfraum des Behandlungsbehälters zu erzielen. Der Volumenstrom kann dabei gesteuert werden, beispielsweise in Abhängigkeit von bekannten Abmessungen und Betriebsparametern des Behandlungsbehälters. Der Volumenstrom kann auch geregelt werden, beispielsweise abhängig von einem Ausgangssignal eines Sensors, der eine Sauerstoffkonzentration oder eine andere Gaskonzentration in dem Dampfraum des Behandlungsmoduls misst.

Der Volumenstrom des in den Behandlungsbehälter zugeführten Inertgases kann so eingestellt werden, dass die Sauerstoffkonzentration in einem Dampfraum des Behandlungsbehälters über dem Badspiegel kleiner als 10 Vol.-%, insbesondere kleiner als 5 Vol.-%, insbesondere kleiner als 2 Vol.-% ist.

Bei dem Verfahren und der Vorrichtung ist es nicht nötig, die Sauerstoffkonzentration im Dampfraum des Behandlungsbehälters bis auf 0 Vol.-% zu senken. Bei einem Ausführungsbeispiel kann der Volumenstrom des in den Behandlungsbehälter zugeführten Inertgases so eingestellt werden, dass die Sauerstoffkonzentration in einem Dampfraum des Behandlungsbehälters über dem Badspiegel im Bereich von 0,1 bis 15 Vol.-%, insbesondere im Bereich von 3 bis 12 Vol.-%, insbesondere im Bereich von 4 bis 8 Vol.-% liegt. Es hat sich gezeigt, dass auch mit einer derartigen Restkonzentration von Sauerstoff Probleme, die bei der Behandlung des Behandlungsgutes mit einer sauerstoff- oder luftempfindlichen Behandlungslösung auftreten können, gut unterdrückt werden können.

Der Menge des in den Behandlungsbehälter pro Zeit zugeführten Inertgases kann so eingestellt werden, dass eine Menge von pro Zeit aus dem Behandlungsbehälter abgegebener Abluft wenigstens 80 % der Summe des pro Zeit zugeführten Inertgases und einer pro Zeit durch Verdunstung der Behandlungsflüssigkeit entstehenden Dampfmenge ist. Die Menge von pro Zeit aus dem Behandlungsbehälter abgegebener Abluft kann wenigstens 90 %, insbesondere wenigstens 100 % dieser Summe betragen. Bei einem Ausführungsbeispiel kann die Menge von pro Zeit aus dem Behandlurigsbehälter abgezogener Abluft zwischen 80 % und 120 % dieser Summe betragen. Auf diese Weise können entstehende Dämpfe sicher abgesaugt werden.

Der Volumenstrom des in den Behandlungsbehälter zugeführten Inertgases kann so eingestellt werden, dass ein Verhältnis zwischen dem Volumenstrom, gemessen in m³/h, zu einem in dem Behandlungsbehälter vorhandenen Volumen der Behandlungsflüssigkeit, gemessen in m³, kleiner als 20:1, insbesondere kleiner als 10:1 ist. Derartige Volumenströme von Inertgas erlauben es, Probleme, die bei der Behandlung des Behandlungsgutes mit einer sauerstoff- oder luftempfindlichen Behandlungslösung auftreten können, zu unterdrücken und den Verbrauch an Inertgas ausreichend gering zu halten.

Der Behandlungsbehälter kann Wartungs- und Bedienöffnungen aufweisen, die jeweils mit wenigstens einem Verschlusselement versehen sein können. Das wenigstens eine Verschlusselement kann mit einer Dichtung versehen sein. Dies erlaubt es, ein Eindringen von Sauerstoff aus einer Umgebung des Behandlungsbehälters über die Wartungs- und Bedienöffnungen zu unterdrücken.

Als Inertgas kann beispielsweise Stickstoff oder Kohlendioxid verwendet werden.

Nach einem weiteren Aspekt wird eine Vorrichtung zum nasschemischen Behandeln von Behandlungsgut, insbesondere von flächigem Behandlungsgut, angegeben. Die Vorrichtung umfasst einen Behandlungsbehälter zum Behandeln des Behandlungsgutes mit einer Behandlungsflüssigkeit, eine Transporteinrichtung zum Transportieren des Behandlungsgutes durch den Behandlungsbehälter und eine Zuführeinrichtung zum Zuführen eines Inertgases in den Behandlungsbehälter.

Da die Vorrichtung eingerichtet ist, um Inertgas in den Behandlungsbehälter zuzuführen, kann Luftsauerstoff in dem Behandlungsbehälter verdrängt werden. Die Vorrichtung ist entsprechend eingerichtet, um die Sauerstoffkonzentration in dem Behandlungsbehälter und somit den Eintrag von Sauerstoff in die Behandlungsflüssigkeit zu verringern. Insbesondere kann ein Gaspolster oberhalb eines Bades der Behandlungsflüssigkeit und unmittelbar angrenzend an die Badoberfläche erzeugt werden, das einen geringen Anteil an Sauerstoff oder keinen Sauerstoff enthält. Dies erlaubt es, in einer Durchlaufanlage einen Sauerstoffeintrag in die Behandlungslösung zu verringern.

Die Vorrichtung kann eingerichtet sein, um das Verfahren nach den verschiedenen hier beschriebenen Ausführungsbeispielen durchzuführen, wobei die im Zusammenhang mit den korrespondierenden Weiterbildungen des Verfahrens angegebenen Wirkungen erreicht werden können. Weiterbildungen der Vorrichtung sind auch in den abhängigen Ansprüchen angegeben, wobei jeweils die im Zusammenhang mit den korrespondierenden Weiterbildungen des Verfahrens angegebenen Wirkungen erreicht werden können.

Nach einem weiteren Aspekt der Erfindung wird ein Gut, insbesondere eine Leiterplatte oder eine Leiterfolie angegeben, das mit dem Verfahren nach einem Aspekt oder Ausführungsbeispiel behandelt wurde.

Verfahren und Vorrichtungen nach verschiedenen Ausführungsbeispielen der Erfindung erlauben es, einen Sauerstoffeintrag in eine Behandlungsflüssigkeit zu unterdrücken. Insbesondere können mit Verfahren und Vorrichtungen nach verschiedenen Ausführungsbeispielen bei einer Durchlaufanlage, bei der Behandlungsgut in einen Behandlungsbehälter hinein und nach der Behandlung mit der Behandlungsflüssigkeit aus dem Behandlungsbehälter transportiert wird, Probleme abgemildert werden, die aus einem Sauerstoffeintrag in die Behandlungsflüssigkeit resultieren können.

Ausführungsbeispiele der Erfindung können in Anlagen eingesetzt werden, in denen Behandlungsgut transportiert wird, beispielsweise in Anlagen zur chemischen, insbesondere elektrochemischen, Behandlung von Leiterplatten, folienartigem Material, Leiterbahnen oder dergleichen. Jedoch sind die Ausführungsbeispiele nicht auf dieses Anwendungsgebiet beschränkt.

Die Erfindung wird nachfolgend anhand eines bevorzugten oder vorteilhaften Ausführungsbeispiels unter Bezugnahme auf die beigefügten Zeichnungen näher erläutert.
Fig. 1 ist eine schematische Schnittansicht einer Vorrichtung zum Behandeln von flächigem Behandlungsgut nach einem Ausführungsbeispiel.
Fig. 2 ist eine weitere schematische Schnittansicht der Vorrichtung von Fig. 1.

Die Ausführungsbeispiele werden im Kontext einer Anlage zum Behandeln von Behandlungsgut beschrieben, bei der das Behandlungsgut in einer horizontalen Transportebene transportiert wird. Richtungs- oder Positionsangaben, die sich auf das Behandlungsgut beziehen, werden konventionsgemäß in Bezug auf die Transportrichtung angegeben. Die Richtung, die beim Transportieren des Behandlungsgutes parallel bzw. antiparallel zur Transportrichtung ist, wird als Längsrichtung bezeichnet.

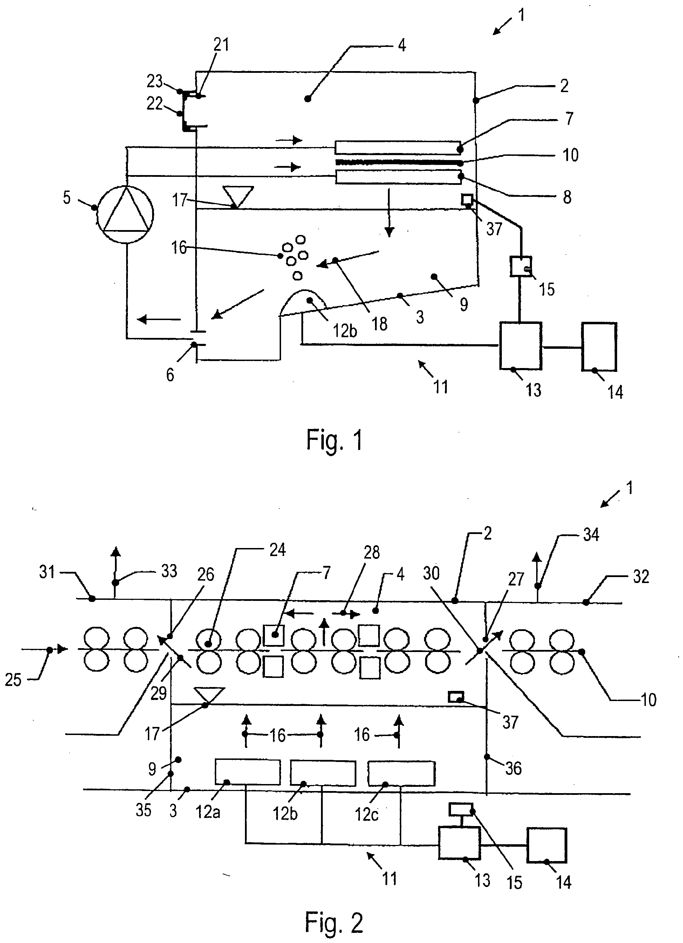

Fig. 1 und Fig. 2 zeigen schematische Schnittansichten einer Vorrichtung 1 zum Behandeln von flächigem Behandlungsgut 10, bei dem es sich beispielsweise um eine gedruckte Schaltung, wie eine Leiterplatte, Leiterfolie oder dergleichen handeln kann. Dabei ist bei der Schnittansicht von Fig. 1 die Zeichenebene orthogonal zu der Transportrichtung 25 gerichtet, und in der Schnittansicht von Fig. 2 ist die Zeichenebene parallel zu der Transportrichtung 25 gerichtet.

Die Vorrichtung 1 umfasst ein Behandlungsmodul mit einem Behandlungsbehälter 2, in dem das Behandlungsgut mit einer Behandlungsflüssigkeit behandelt wird. Die Behandlungsflüssigkeit kann insbesondere eine sauerstoff- bzw. luftempfindliche Behandlungslösung sein, beispielsweise ein chemisches Zinnbad. Das Behandlungsmodul mit dem Behandlungsbehälter 2 kann Teil einer Prozesslinie mit weiteren Behandlungsmodulen 31, 32 sein, die benachbart zu dem Behandlungsmodul mit dem Behandlungsbehälter 2 angeordnet sind und in denen das Behandlungsgut 10 jeweils mit einer anderen Prozesschemikalie oder einer Spülflüssigkeit behandelt wird. In dem Behandlungsbehälter 2 kann das Behandlungsgut 10 in herkömmlicher Weise mit der Behandlungsflüssigkeit in Kontakt gebracht werden. Beispielsweise kann der Behandlungsbehälter 2 einen Sumpf 3 aufweisen, in dem die Behandlungsflüssigkeit 9 bis zu einem Niveau 17 angestaut ist. Ein weiterer Bereich in dem Behandlungsbehälter 2, der im Folgenden als Dampfraum 4 bezeichnet wird, ist nicht mit Behandlungsflüssigkeit gefüllt und kann verschiedene Gase enthalten. Bei Ausführungsformen kann der Dampfraum 4 definiert werden als das Teilvolumen des Behandlungsbehälters 2, das nicht mit Flüssigkeit gefüllt ist. In dem Dampfraum 4 kann auch verdunstete Behandlungsflüssigkeit in der Gasphase enthalten sein.

Der Behandlungsbehälter 2 weist ein Gehäuse auf, das eine Hülle des Behandlungsbehälters 2 definiert, jedoch nicht gasdicht ausgebildet sein muss. Insbesondere kann das Gehäuse in einer Trennwand 35, die den Behandlungsbehälter 2 von dem benachbarten Behandlungsmodul 31 in der Transportrichtung 25 abgrenzt, einen Einlaufschlitz 26 aufweisen, über den das Behandlungsgut 10 in den Behandlungsbehälter 2 transportiert wird. Das Gehäuse kann in einer weiteren Trennwand 36, die den Behandlungsbehälter 2 an seinem entgegengesetzten Ende von dem benachbarten Behandlungsmodul 32 in der Transportrichtung 25 abgrenzt, einen Auslaufschlitz 27 aufweisen, über den das Behandlungsgut 10 aus dem Behandlungsbehälter 2 transportiert wird. Eine Transporteinrichtung, die Transportelemente, beispielsweise Transportwalzenpaare 24, umfasst, ist vorgesehen, um das Behandlungsgut 10 durch den Behandlungsbehälter 2 zu fördern.

In einem unteren Abschnitt des Behandlungsbehälters 2 ist eine Ansaugöffnung 6 vorgesehen, mit der Behandlungsflüssigkeit von einer Fördereinrichtung, beispielsweise einer Pumpe 5, aus dem Sumpf 3 des Behandlungsbehälters 2 gefördert wird. Die Pumpe 5 fördert die Behandlungsflüssigkeit aus dem Sumpf 3 zu Behandlungsorganen 7, 8, die eine Anströmdüse, Schwalldüse, Sprühdüse oder dergleichen umfassen können. Aus den Behandlungsorganen 7, 8 wird die Behandlungsflüssigkeit abgegeben, um das an den Behandlungsorganen 7, 8 vorbeigeführte Behandlungsgut 10 mit der Behandlungsflüssigkeit zu behandeln. Von den Behandlungsorganen 7, 8 bzw. von dem Behandlungsgut 10 kann die Behandlungsflüssigkeit zurück in den Sumpf 3 strömen, um von der Pumpe 5 erneut umgewälzt zu werden.

Die Vorrichtung 1 ist weiterhin so eingerichtet, dass ein Inertgas in den Behandlungsbehälter 2 zugeführt werden kann. Das zugeführte Inertgas kann beispielsweise Stickstoff oder Kohlendioxid sein. Dazu weist die Vorrichtung 1 eine Zuführeinrichtung 11 zum Zuführen des Inertgases auf. Die Zuführeinrichtung 11 weist mehrere Zuführelemente 12a, 12b, 12c auf, aus denen das Inertgas 16 unterhalb des Niveaus 17 in die Behandlungsflüssigkeit 9 abgegeben werden kann, die in dem Sumpf 3 des Behandlungsbehälters 2 angestaut ist.

Um das Inertgas 16 in die Behandlungsflüssigkeit 9 abzugeben, sind die Zuführelemente 12a, 12b, 12c der Zuführeinrichtung 11 derart positioniert, dass sie unterhalb des Niveaus 17, bis zu dem die Behandlungsflüssigkeit 9 in dem Sumpf 3 während des Betriebs der Vorrichtung 1 minimal angestaut wird, das Inertgas abgeben. Die Zuführelemente 12a, 12b, 12c der Zuführeinrichtung 11 können insbesondere so positioniert sein, dass sie mindestens 10 mm, insbesondere mindestens 100 mm unterhalb des Niveaus 17 das Inertgas in die Behandlungsflüssigkeit 9 abgeben.

Die Zuführelemente 12a, 12b, 12c der Zuführeinrichtung 11 sind weiterhin derart positioniert, dass sie oberhalb des Ansaugöffnung, durch die die Pumpe 5 die Behandlungsflüssigkeit aus dem Sumpf 3 fördert, das Inertgas an die Behandlungsflüssigkeit abgeben.

Wenigstens ein Zuführelement 12b der Zuführeinrichtung 11 ist in Längsrichtung des Behandlungsbehälters 2 beabstandet von den zwei den Behandlungsbehälter 2 in der Transportrichtung 25 begrenzenden Trennwänden 35, 36 angeordnet. Das Zuführelement 12b der Zuführeinrichtung 11 kann insbesondere so angeordnet sein, dass es jedenfalls auch an einer Mittelposition zwischen den beiden Trennwänden 35, 36 Inertgas 16 in die Behandlungsflüssigkeit 9 abgeben kann. Das Inertgas wird von dem Zuführelement 12b an einer Position in den Behandlungsbehälter 2 zugeführt, die in Längsrichtung des Behandlungsbehälters 2 von dem Einlaufschlitz 26 und dem Auslaufschlitz 27 beabstandet ist. Auch die Zuführelemente 12a, 12c der Zuführeinrichtung 11 sind in Längsrichtung des Behandlungsbehälters 2 von den den Behandlungsbehälter 2 in der Transportrichtung 25 begrenzenden Trennwänden 35, 36 beabstandet angeordnet und führen das Inertgas 16 an einer Position in den Behandlungsbehälter zu, die in Längsrichtung des Behandlungsbehälters 2 von dem Einlaufschlitz 26 und dem Auslaufschlitz 27 beabstandet ist.

Wenigstens ein Zuführelement 12b der Zuführeinrichtung 11 und vorteilhaft alle Zuführelemente 12a, 12b, 12c der Zuführeinrichtung 11 sind so in dem Behandlungsbehälter positioniert, dass sie das Inertgas 16 dort in die in dem Sumpf 3 angestaute Behandlungsflüssigkeit 9 abgeben, wo ein verhältnismäßig großer Anteil der Behandlungsflüssigkeit rasch über die Ansaugöffnung 6 zu der Pumpe 5 transportiert wird. Dazu können die Zuführelemente 12a, 12b, 12c so positioniert sein, dass sie das Inertgas 16 dort in die in dem Sumpf 3 angestaute Behandlungsflüssigkeit 9 abgeben, wo die angestaute Behandlungsflüssigkeit 9 eine endliche Strömungsgeschwindigkeit 18 aufweist, mit der die Behandlungsflüssigkeit 9 zu der Ansaugöffnung 6 strömt. Auf diese Weise kann eine Konzentration von Sauerstoff oder Schadgasen in der Behandlungsflüssigkeit 9 verringert werden, bevor diese zu dem Behandlungsgut 10 gefördert und umgewälzt wird. Dies ermöglicht eine rasche Reduzierung von Luftsauerstoff und Schadgasen in der Behandlungsflüssigkeit in dem Behandlungsbehälter 2. Die durch die Zugabe von Inertgas resultierende Verwirbelung der angestauten Behandlungsflüssigkeit 9 kann ein Absetzen von in der Behandlungsflüssigkeit suspendierten Partikeln unterdrücken und so ein Filtrieren erleichtern.

Die Zuführelemente 12a, 12b, 12c der Zuführeinrichtung 11 können jeweils als poröse Fritten ausgebildet sein. Alternativ können die Zuführelemente 12a, 12b, 12c der Zuführeinrichtung 11 jeweils eine Anordnung kleiner Löcher aufweisen, durch die das Inertgas 16 in die Behandlungsflüssigkeit 9 abgegeben wird. Die Zuführelemente 12a, 12b, 12c können als Kunststoffteile, insbesondere als rohrförmige Kunststoffteile ausgebildet sein.

Eine kontrollierbare Einrichtung bzw. ein kontrollierbares Element 13, beispielsweise ein steuerbares Ventil, ist an einer Zuleitung des Inertgases vorgesehen. Mit der kontrollierbaren Einrichtung 13 kann ein Volumenstrom des Inertgases von einem Reservoir 14 des Inertgases zu den Zuführelementen 12a, 12b, 12c eingestellt werden. Eine Steuerung 15 ist mit der kontrollierbaren Einrichtung 13 gekoppelt, um den Volumenstrom zu steuern oder zu regeln. Die Steuerung 15 kann mit einem Sensor 37 oder mit mehreren Sensoren 37 in dem Behandlungsbehälter gekoppelt sein. Der Sensor 37 oder die Sensoren können eingerichtet sein, um die Konzentration wenigstens eines Gases im dem Dampfraum 4 zu erfassen. Beispielsweise kann der Sensor 37 eingerichtet sein, um die Konzentration von Sauerstoff in dem Dampfraum 4 über der angestauten Behandlungsflüssigkeit 9 zu erfassen und ein die Konzentration anzeigendes Signal an die Steuerung 15 bereitzustellen. Alternativ oder zusätzlich kann der Sensor 37 eingerichtet sein, um die Konzentration des Inertgases in dem Dampfraum 4 zu erfassen und ein die Konzentration anzeigendes Signal an die Steuerung 15 bereitzustellen. Der Sensor 37 bzw. die Sensoren können so eingerichtet sein, dass sie die Konzentration bzw. die Konzentrationen der entsprechenden Gase oberhalb des Niveaus 17 der Behandlungsflüssigkeit, insbesondere knapp oberhalb des Niveaus 17 der Behandlungsflüssigkeit messen. Die Steuerung 15 kann ein Stellsignal an die kontrollierbare Einrichtung 13 als Antwort auf die erfasste Konzentration bereitstellen, um den Volumenstrom des in den Behandlungsbehälter 2 zugeführten Inertgases abhängig von der Konzentration zu regeln. Bei einem weiteren Ausführungsbeispiel kann die Steuerung 15 den Volumenstrom des zugeführten Inertgases abhängig von bekannten geometrischen Eigenschaften des Behandlungsbehälters 2 sowie von Betriebsparametern der Vorrichtung 1, die beispielsweise die Menge der Behandlungsflüssigkeit 9 in dem Behandlungsbehälter 2 umfassen können, steuern.

Durch die Regelung des in den Behandlungsbehälter zugeführten Volumenstroms von Inertgas durch die Steuerung 15 kann der zugeführte Volumenstrom bzw. die zugeführte Menge von Inertgas so gewählt werden, dass sie möglichst klein ist. Der zugeführte Volumenstrom von Inertgas kann insbesondere so gewählt werden, dass eine gewünschte Sauerstoffkonzentration in dem Dampfraum 4 des Behandlungsbehälters 2 bei möglichst geringer Zufuhr von Inertgas erzielt wird. Dabei kann die Zufuhr von Inertgas so geregelt werden, dass nicht notwendig eine Sauerstoffkonzentration von Null erreicht werden muss. Beispielsweise hat sich gezeigt, dass zufriedenstellende Ergebnisse im Hinblick auf einen Sauerstoffeintrag in der Behandlungsflüssigkeit bereits erzielt werden können, wenn die Sauerstoffkonzentration in dem Dampfraum 4 über dem Badspiegel 17 kleiner als 10 Vol.-%, insbesondere kleiner als 5 Vol.-%, insbesondere kleiner als 2 Vol.-% ist. Die Zufuhr von Inertgas kann so geregelt werden, dass die Sauerstoffkonzentration in dem Dampfraum 4 über dem Badspiegel 17 im Bereich von 0,1 bis 15 Vol.-%, insbesondere im Bereich von 3 bis 12 Vol.-%, insbesondere im Bereich von 4 bis 8 Vol.-% liegt.

Weitere Kriterien können von der Steuerung 15 angewandt werden, um die Zufuhr von Inertgas zu regeln oder zu steuern. Beispielsweise kann die Steuerung 15 die Zufuhr des Inertgases so einstellen, dass ein Verhältnis zwischen dem Volumenstrom des zugeführten Inertgases, gemessen in m³/h, zu einem in dem Behandlungsbehälter vorhandenen Volumen der Behandlungsflüssigkeit, gemessen in m³, kleiner als 20:1, insbesondere kleiner als 10:1 ist.

Wie schematisch in Fig. 2 dargestellt, wird Abluft aus dem Behandlungsbehälter 2 über den Einlaufschlitz 26 und den Auslaufschlitz 27 abgezogen, durch die das Behandlungsgut 10 in den Behandlungsbehälter 2 und aus dem Behandlungsbehälter 2 transportiert wird. Der Strom von Abluft 29 durch den Einlaufschlitz 26 und der Strom von Abluft 30 durch den Auslaufschlitz 27 kann im Wesentlichen zugeführtes Inertgas 28, das in dem Dampfraum 4 zu den Ein- und Auslaufschlitzen 26, 27 strömt, verdunstete Behandlungsflüssigkeit sowie Anteile von Schadgasen oder von in den Behandlungsbehälter 2 angesaugter Luft enthalten. Luft kann beispielsweise über Undichtigkeiten in den Behandlungsbehälter 2 gelangen.

Um einen Eintritt von Luft aus der Umgebung in den Behandlungsbehälter 2 zu verringern, können Wartungs- und Bedienöffnungen des Behandlungsbehälters 2 abgedichtet sein. Der Behandlungsbehälter 2 kann beispielsweise eine schematisch dargestellte Wartungsöffnung 21 aufweisen, die mit einem Deckel 22 verschließbar ist. Der Deckel 22 weist eine Dichtung 23 auf, um das Eindringen von Luft zu unterdrücken.

Die Vorrichtung 1 kann so eingerichtet sein, dass die Abluft 29, 30 aus dem Behandlungsbehälter 2 in die benachbarten Behandlungsmodule 31, 32 strömt. Um ein Einströmen von Luft in den Behandlungsbehälter 2 aus den Behandlungsmodulen 31, 32 zu unterdrücken, kann bei der Vorrichtung 1 eine endliche Strömungsgeschwindigkeit von Gasen durch den Einlaufschlitz 26 und den Auslaufschlitz 27 eingestellt werden, wobei die Strömungsgeschwindigkeit derart gerichtet ist, dass die Gase aus dem Behandlungsbehälter 2 in die benachbarten Behandlungsmodule 31, 32 strömen. An Absaugbereichen 33, 34, die an den benachbarten Behandlungsmodulen 31, 32 vorgesehen sind, kann die Abluft aus dem Behandlungsbehälter 2 über die vor- und nachgeschalteten Behandlungsmodule 31, 32 abgesaugt werden.

Wie bereits erläutert sind die Bereiche des Behandlungsbehälters 2, an denen die Zuführelemente 12a, 12b, 12c das Inertgas 16 in den Behandlungsbehälter 2 zuführen, in der Transportrichtung 25 von dem Einlaufschlitz 26 und dem Auslaufschlitz 27 beabstandet.

Dies fördert die Verteilung des Inertgases 16 entlang der Längsrichtung des Behandlungsbehälters 2, und somit die Verdrängung von Sauerstoff.

Eine Absaugleistung und/oder die Zufuhr von Inertgas in den Behandlungsbehälter 2 kann so eingestellt werden, dass ein Eindringen von Luft in den Behandlungsbehälter 2 über die Ein- und Auslaufschlitze 26, 27 unterdrückt wird. Die Absaugleistung kann so gewählt werden, dass eine pro Zeit abgesaugte Menge von Abluft 26, 27 mindestens so groß ist wie die pro Zeit zugeführte Menge an Inertgas plus die pro Zeit verdunstete Menge von Behandlungsflüssigkeit.

Abwandlungen des in den Figuren dargestellten und detailliert beschriebenen Ausführungsbeispiels können bei weiteren Ausführungsbeispielen realisiert werden.

Während im Kontext von Ausführungsbeispielen eine Vorrichtung beschrieben wurde, in der das Behandlungsgut horizontal transportiert wird, kann bei weiteren Ausführungsbeispielen das Behandlungsgut auch in einer vertikalen Ebene transportiert werden.

Während im Kontext von Ausführungsbeispielen Vorrichtungen und Verfahren beschrieben wurden, bei denen das Inertgas in die im Sumpf angestaute Behandlungsflüssigkeit abgegeben wird, kann bei weiteren Ausführungsbeispielen das Inertgas alternativ oder zusätzlich auch an einer Position oder in einem Bereich in den Behandlungsbehälter zugeführt werden, in dem keine Behandlungsflüssigkeit angestaut ist.

Während im Kontext von Ausführungsbeispielen Vorrichtungen und Verfahren beschrieben wurden, bei denen oberhalb des Flüssigkeitsniveaus der angestauten Behandlungsflüssigkeit Behandlungsorgane vorgesehen sind, kann das Behandlungsgut bei weiteren Ausführungsbeispielen auch einer Tauchbehandlung unterzogen werden. Es müssen nicht notwendig separate Behandlungsorgane vorgesehen sein, mit denen das Behandlungsgut mit der Behandlungsflüssigkeit angeströmt wird.

Die Vorrichtungen und Verfahren nach den verschiedenen Ausführungsbeispielen können bei der Behandlung von Waren mit leitfähigen Strukturen, wie beispielsweise Leiterplatten, Leiterfolien, Solarzellen oder Komponenten für Solarzellen und dergleichen, eingesetzt werden, ohne dass ihre Anwendung darauf beschränkt ist. Die Vorrichtungen und Verfahren nach den verschiedenen Ausführungsbeispielen können insbesondere zur Behandlung von Behandlungsgut mit sauerstoff- oder luftempfindlicher Behandlungslösung eingesetzt werden.

## Patentansprüche

1. Verfahren zum nasschemischen Behandeln von Behandlungsgut (10), insbesondere von flächigem Behandlungsgut (10), in einer Durchlaufanlage,
wobei das Behandlungsgut (10) durch einen Behandlungsbehälter (2) transportiert und in dem Behandlungsbehälter (2) mit einer Behandlungsflüssigkeit (9) behandelt wird,
wobei ein Inertgas (16) in den Behandlungsbehälter (2) zugeführt wird,
**dadurch gekennzeichnet,**
**dass** der Behandlungsbehälter (2) einen Einlaufschlitz (26), durch den das Behandlungsgut (10) in den Behandlungsbehälter (2) transportiert wird, und einen Auslaufschlitz (27), durch den das Behandlungsgut (10) aus dem Behandlungsbehälter (2) transportiert wird, aufweist, wobei das Inertgas (16) durch den Einlaufschlitz (26) und/oder den Auslaufschlitz (27) aus dem Behandlungsbehälter (2) abgezogen wird.

2. Verfahren nach Anspruch 1,
wobei das Inertgas (16) in wenigstens einem ersten Bereich (12a, 12b, 12c) des Behandlungsbehälters (2) in den Behandlungsbehälter (2) zugeführt wird, und wobei das Inertgas (16) in einem von dem ersten Bereich beabstandeten zweiten Bereich (29, 30) des Behandlungsbehälters (2) aus dem Behandlungsbehälter (2) abgegeben wird.

3. Verfahren nach Anspruch 1 oder 2,
wobei das Inertgas (16) über einen Randbereich (35, 36) des Behandlungsbehälters (2) aus dem Behandlungsbehälter (2) abgezogen wird.

4. Verfahren nach einem der vorhergehenden Ansprüche,
wobei eine endliche Strömungsgeschwindigkeit von Gasen durch den Einlaufschlitz (26) und den Auslaufschlitz (27) eingestellt wird, die so gerichtet ist, dass Gase aus dem Behandlungsbehälter (2) in benachbarte Behandlungsmodule (31, 32) strömen, und
wobei Absaugbereiche (33, 34) zum Absaugen von Abluft an den benachbarten Behandlungsmodulen (31, 32) vorgesehen sind.

5. Verfahren nach einem der vorhergehenden Ansprüche,
wobei das Inertgas (16) wenigstens in die Behandlungsflüssigkeit (9) eingebracht wird, um das Inertgas (16) in den Behandlungsbehälter (2) zuzuführen.

6. Verfahren nach einem der vorhergehenden Ansprüche,
wobei der Behandlungsbehälter (2) einen Sumpf (3) aufweist, in dem die Behandlungsflüssigkeit (9) wenigstens bis zu einem Niveau (17) angestaut wird und aus dem die Behandlungsflüssigkeit (9) zu einem Behandlungsorgan (7, 8) gefördert wird, wobei das Inertgas (16) unterhalb des Niveaus (17) in den Behandlungsbehälter (2) zugeführt wird.

7. Verfahren nach Anspruch 6,
wobei das Inertgas in einem Bereich in die im Sumpf (3) angestaute Behandlungsflüssigkeit (9) eingebracht wird, in dem eine endliche Strömungsgeschwindigkeit zu einer Ansaugöffnung (6) einer Fördereinrichtung (5) vorhanden ist, die die Behandlungsflüssigkeit (9) zu dem Behandlungsorgan (7, 8) fördert.

8. Verfahren nach einem der vorhergehenden Ansprüche,
wobei ein Volumenstrom des in den Behandlungsbehälter (2) zugeführten Inertgases (16) so eingestellt wird, dass eine Sauerstoffkonzentration in einem Dampfraum (4) des Behandlungsbehälters (2) im Bereich von 0,1 bis 15 Vol.-%, insbesondere im Bereich von 3 bis 12 Vol.-%, insbesondere im Bereich von 4-8 Vol.-% liegt.

9. Verfahren nach einem der vorhergehenden Ansprüche,
wobei ein Volumenstrom des in den Behandlungsbehälter (2) zugeführten Inertgases (16) so eingestellt wird, dass ein Verhältnis zwischen dem Volumenstrom, gemessen in m³/h, zu einem in dem Behandlungsbehälter vorhandenen Volumen der Behandlungsflüssigkeit, gemessen in m³, kleiner als 20:1, insbesondere kleiner als 10:1 ist

10. Vorrichtung zum nasschemischen Behandeln von Behandlungsgut (10), insbesondere von flächigem Behandlungsgut (10), umfassend
einen Behandlungsbehälter (2) zum Behandeln des Behandlungsgutes (10) mit einer Behandlungsflüssigkeit (9),
eine Transporteinrichtung (24) zum Transportieren des Behandlungsgutes (10) durch den Behandlungsbehälter (2) und
eine Zuführeinrichtung (11) zum Zuführen eines Inertgases (16) in den Behandlungsbehälter (2),
**dadurch gekennzeichnet,**
**dass** der Behandlungsbehälter (2) einen Einlaufschlitz (26) und einen Auslaufschlitz (27), für das Behandlungsbehälter (2) aufweist, und
**dass** die Vorrichtung eingerichtet ist, um das Inertgas (16) durch den Einlaufschlitz (26) und/oder den Auslaufschlitz (27) aus dem Behandlungsbehälter (2) abzuziehen.

11. Vorrichtung nach Anspruch 10,
wobei die Zuführeinrichtung (11) eingerichtet ist, um das Inertgas (16) in wenigstens einem Zuführbereich (12a, 12b, 12c) des Behandlungsbehälters (2) in den Behandlungsbehälter (2) zuzuführen, und wobei der Behandlungsbehälter (2) wenigstens eine Abgabeöffnung (26, 27) zum Abgeben von Abluft (29, 30) aus dem Behandlungsbehälter (2) aufweist, wobei die wenigstens eine Abgabeöffnung (26, 27) beabstandet von dem wenigstens einen Zuführbereich (12a, 12b, 12c) vorgesehen ist.

12. Vorrichtung nach Anspruch 10 oder 11,
wobei die Zuführeinrichtung (11) eingerichtet und angeordnet ist, um das Inertgas (16) in die Behandlungsflüssigkeit (9) einzubringen.

13. Vorrichtung nach einem der Ansprüche 10-12,
wobei der Behandlungsbehälter (2) einen Sumpf (3) aufweist und eine Fördereinrichtung (5) zum Fördern von Behandlungsflüssigkeit (9) aus dem Sumpf (3) zu einem Behandlungsorgan (7, 8) des Behandlungsbehälters (2) vorgesehen ist, wobei die Zuführeinrichtung (11) eingerichtet ist, um das Inertgas (16) in eine in dem Sumpf (3) angestaute Behandlungsflüssigkeit (9) einzuleiten.

14. Vorrichtung nach Anspruch 13,
wobei die Zuführeinrichrichtung (11) eingerichtet ist, um das Inertgas in einem Bereich in die im Sumpf (3) angestaute Behandlungsflüssigkeit (9) einzuleiten, in dem eine endliche Strömungsgeschwindigkeit zu einer Ansaugöffnung (6) einer Fördereinrichtung (5) vorhanden ist, wobei die Fördereinrichtung (5) eingerichtet ist, um die Behandlungsflüssigkeit (9) zu dem Behandlungsorgan (7, 8) zu fördern.

15. Vorrichtung nach einem der Ansprüche 10-14,
umfassend eine Steuerungs- oder Regelungseinrichtung (13, 15, 37) zum Einstellen eines Volumenstroms des Inertgases (16), um in einem Dampfraum (4) des Behandlungsbehälters (2) eine Sauerstoffkonzentration im Bereich von 0,1 bis 15 Vol.-%, insbesondere im Bereich von 3 bis 12 Vol.-%, insbesondere im Bereich von 4-8 Vol.-% einzustellen.

## Claims

1. Method for the wet-chemical treatment of material to be treated (10), in particular of flat material to be treated (10), in a continuous process plant,
wherein the material to be treated (10) is transported through a treatment vessel (2) and is treated in the treatment vessel (2) with a treatment liquid (9),
wherein an inert gas (16) is fed into the treatment vessel (2),
**characterized in that**
the treatment vessel (2) has an inlet slot (26), through which the material to be treated (10) is transported into the treatment vessel (2), and an outlet slot (27), through which the material to be treated (10) is transported out of the treatment vessel (2), the inert gas (16) being drawn off from the treatment vessel (2) through the inlet slot (26) and/or the outlet slot (27).

2. Method according to claim 1,
wherein the inert gas (16) is fed into the treatment vessel (2) in at least one first region (12a, 12b, 12c) of the treatment vessel (2), and wherein the inert gas (16) is discharged from the treatment vessel (2) in a second region (29, 30) of the treatment vessel (2) that is spaced from the first region.

3. Method according to claim 1 or 2,
wherein the inert gas (16) is removed from the treatment vessel (2) via an edge region (35, 36) of the treatment vessel (2).

4. Method according to any one of the preceding claims,
wherein a finite flow velocity of gases through the inlet slot (26) and the outlet slot (27) is established, the flow velocity being so oriented that the gases flow from the treatment vessel (2) into adjacent treatment modules (31, 32), and
wherein suction regions (33, 34) are provided at the adjacent treatment modules (31, 32) to remove waste air by suction.

5. Method according to any one of the preceding claims,
wherein the inert gas (16) is introduced at least into the treatment liquid (9) in order to feed the inert gas (16) into the treatment vessel (2).

6. Method according to any one of the preceding claims,
wherein the treatment vessel (2) has a sump (3) in which the treatment liquid (9) accumulates at least to a level (17) and from which the treatment liquid (9) is fed to a treatment member (7, 8), the inert gas (16) being fed into the treatment vessel (2) below the level (17).

7. Method according to claim 6,
wherein the inert gas is introduced into the treatment liquid (9) accumulated in the sump (3) in a region in which there is a finite flow velocity to a suction opening (6) of a conveyor device (5) that conveys the treatment liquid (9) to the treatment member (7, 8).

8. Method according to any one of the preceding claims,
wherein a volume flow rate of the inert gas (16) fed into the treatment vessel (2) is established such that an oxygen concentration in a vapour space (4) of the treatment vessel (2) is in the range from 0.1 to 15 vol.%, in particular in the range from 3 to 12 vol.%, in particular in the range from 4 to 8 vol.%.

9. Method according to any one of the preceding claims,
wherein the volume flow rate of the inert gas (16) fed to the treatment vessel (2) is established such that a ratio between the volume flow rate, measured in m³/h, and a volume of the treatment liquid, measured in m³, present in the treatment vessel is less than 20:1, in particular less than 10:1

10. Device for the wet-chemical treatment of material to be treated (10), in particular of flat material to be treated (10), comprising
a treatment vessel (2) for treating the material to be treated (10) with a treatment liquid (9),
a transport device (24) for transporting the material to be treated (10) through the treatment vessel (2), and
a feed device (11) for feeding an inert gas (16) into the treatment vessel (2),
**characterized in that**
the treatment vessel (2) has an inlet slot (26) and an outlet slot (27) for the material to be treated (10), and
the device is configured to draw off the inert gas (16) from the treatment vessel (2) through the inlet slot (26) and/or the outlet slot (27).

11. Device according to claim 10,
wherein the feed device (11) is configured to feed the inert gas (16) into the treatment vessel (2) in at least one feed region (12a, 12b, 12c) of the treatment vessel (2), and wherein the treatment vessel (2) has at least one discharge opening (26, 27) for discharging waste air from the treatment vessel (2), the at least one discharge opening (26, 27) being provided spaced from the at least one feed region (12a, 12b, 12c).

12. Device according to claim 10 or 11,
wherein the feed device (11) is configured and disposed to introduce the inert gas (16) into the treatment liquid (9).

13. Device according to any one of claims 10-12,
wherein the treatment vessel (2) has a sump (3) and a conveyor device (5) for conveying treatment liquid (9) from the sump (3) to a treatment member (7, 8) of the treatment vessel (2), the feed device (11) being configured to introduce the inert gas (16) into a treatment liquid (9) accumulated in the sump (3).

14. Device according to claim 13,
wherein the feed device (11) is configured to introduce the inert gas (16) into the treatment liquid (9) accumulated in the sump (3) in a region in which there is a finite flow velocity to a suction opening (6) of a conveyor device (5), the conveyor device (5) being configured to convey the treatment liquid (5) from the sump (3) to the treatment member (7, 8).

15. Device according to any one of claims 10-14,
comprising a control or regulating device (13, 15, 37) for establishing a volume flow rate of the inert gas (16) in order to establish in a vapour space (4) of the treatment vessel (2) an oxygen concentration in the range from 0.1 to 15 vol.%, in particular in the range from 3 to 12 vol.%, in particular in the range from 4 to 8 vol.%.

## Revendications

1. Procédé de traitement par voie humide de produits à traiter (10), en particulier de produits à traiter (10) plats, dans une installation à fonctionnement continu,
dans lequel le produit à traiter (10) est transporté à travers un récipient de traitement (2) et est traité dans le récipient de traitement (2) avec un liquide de traitement (9),
dans lequel un gaz inerte (16) est amené dans le récipient de traitement (2),
**caractérisé en ce que**
le récipient de traitement (2) comporte une fente d'entrée (26), par laquelle le produit à traiter (10) est transporté dans le récipient de traitement (2), et une fente de sortie (27), par laquelle le produit à traiter (10) est transporté hors du récipient de traitement (2),
dans lequel le gaz inerte (16) est extrait du récipient de traitement (2) par la fente d'entrée (26) et/ou par la fente de sortie (27).

2. Procédé selon la revendication 1,
dans lequel le gaz inerte (16) est amené dans le récipient de traitement (2) dans au moins une première zone (12a, 12b, 12c) du récipient de traitement (2) et dans lequel le gaz inerte (16) est extrait du récipient de traitement (2) dans une deuxième zone (29, 30), distante de la première zone, du récipient de traitement (2).

3. Procédé selon la revendication 1 ou 2,
dans lequel le gaz inerte (16) est extrait du récipient de traitement (2) par l'intermédiaire d'une zone de bord (35, 36) du récipient de traitement (2).

4. Procédé selon l'une quelconque des revendications précédentes,
dans lequel on règle une vitesse d'écoulement finie de gaz à travers la fente d'entrée (26) et la fente de sortie (27), laquelle vitesse d'écoulement est réglée de telle sorte que des gaz issus du récipient de traitement (2) s'écoulent dans des modules de traitement voisins (31, 32) et
dans lequel des zones d'aspiration (33, 34) sont prévues pour aspirer de l'air sortant au niveau des modules de traitement voisins (31, 32).

5. Procédé selon l'une quelconque des revendications précédentes,
dans lequel le gaz inerte (16) est introduit au moins dans le liquide de traitement (9) pour amener le gaz inerte (16) dans le récipient de traitement (2).

6. Procédé selon l'une quelconque des revendications précédentes,
dans lequel le récipient de traitement (2) comporte un bassin (3) dans lequel le liquide de traitement (9) est accumulé au moins jusqu'à un niveau (17) et hors duquel le liquide de traitement (9) est transporté jusqu'à un organe de traitement (7, 8), dans lequel le gaz inerte (16) est amené dans le récipient de traitement (2) au-dessous du niveau (17).

7. Procédé selon la revendication 6,
dans lequel le gaz inerte est introduit dans le liquide de traitement (9) accumulé dans le bassin (3) dans une zone dans laquelle il existe une vitesse d'écoulement finie vers un orifice d'aspiration (6) d'un dispositif de transport (5) qui transporte le liquide de traitement (9) jusqu'à l'organe de traitement (7, 8).

8. Procédé selon l'une quelconque des revendications précédentes,
dans lequel un flux volumique du gaz inerte (16) amené dans le récipient de traitement (2) est réglé de telle sorte qu'une concentration en oxygène dans un espace à vapeur (4) du récipient de traitement (2) est comprise entre 0,1 et 15 % en volume, en particulier entre 3 et 12 % en volume, en particulier entre 4-8 % en volume.

9. Procédé selon l'une quelconque des revendications précédentes,
dans lequel un flux volumique du gaz inerte (16) amené dans le récipient de traitement (2) est réglé de telle sorte qu'un rapport entre le flux volumique, mesuré en m³/h, et un volume du liquide de traitement présent dans le récipient de traitement, mesuré en m³, est inférieur à 20:1, en particulier inférieur à 10:1.

10. Dispositif de traitement par voie humide de produits à traiter (10), en particulier de produits à traiter (10) plats, comprenant
un récipient de traitement (2) destiné au traitement du produit à traiter (10) avec un liquide de traitement (9),
un dispositif de transport (24) destiné à transporter le produit à traiter (10) à travers le récipient de traitement (2) et
un dispositif d'amenée (11) destiné à l'amenée d'un gaz inerte (16) dans le récipient de traitement (2),
**caractérisé en ce que**
le récipient de traitement (2) comporte une fente d'entrée (26) et une fente de sortie (27) pour le récipient de traitement (2) et
le dispositif est conçu pour extraire le gaz inerte (16) du récipient de traitement (2) via la fente d'entrée (26) et/ou la fente de sortie (27).

11. Dispositif selon la revendication 10,
dans lequel le dispositif d'amenée (11) est conçu pour amener le gaz inerte (16) dans le récipient de traitement (2) dans au moins une zone d'amenée (12a, 12b, 12c) du récipient de traitement (2) et dans lequel le récipient de traitement (2) comporte au moins un orifice d'évacuation (26, 27) destiné à évacuer de l'air sortant (29, 30) du récipient de traitement (2), dans lequel l'au moins un orifice d'évacuation (26, 27) est prévu à une certaine distance de l'au moins une zone d'amenée (12a, 12b, 12c).

12. Dispositif selon la revendication 10 ou 11,
dans lequel le dispositif d'amenée (11) est conçu et agencé pour introduire le gaz inerte (16) dans le liquide de traitement (9).

13. Dispositif selon l'une quelconque des revendications 10 à 12,
dans lequel le récipient de traitement (2) comporte un bassin (3) et un dispositif de transport (5) est prévu pour transporter du liquide de traitement (9) hors du bassin (3) jusqu'à un organe de traitement (7, 8) du récipient de traitement (2), lequel dispositif d'amenée (11) est conçu pour introduire le gaz inerte (16) dans un liquide de traitement (9) accumulé dans le bassin (3).

14. Dispositif selon la revendication 13,
dans lequel le dispositif d'amenée (11) est conçu pour introduire le gaz inerte dans le liquide de traitement (9) accumulé dans le bassin (3) dans une zone dans laquelle il existe une vitesse d'écoulement finie vers un orifice d'aspiration (6) d'un dispositif de transport (5), lequel dispositif de transport (5) est conçu pour transporter le liquide de traitement (9) jusqu'à l'organe de traitement (7, 8).

15. Dispositif selon l'une quelconque des revendications 10-14,
comprenant un dispositif de commande ou de régulation (13, 15, 37) destiné au réglage d'un flux volumique du gaz inerte (16) afin de régler dans un espace à vapeur (4) du dispositif de traitement (2) une concentration en oxygène comprise entre 0,1 et 15 % en volume, en particulier entre 3 et 12 % en volume, en particulier entre 4-8 % en volume.
